# FASCICULE DE BREVET EUROPEEN

(11) **EP 3 799 126 B1**
(45) Date de publication et mention de la délivrance du brevet: **19.07.2023**
(21) Numéro de dépôt: 19306227.0
(22) Date de dépôt: 30.09.2019
(51) Int. Cl.: H10K 59/19

(54) **DISPOSITIF D'ANIMATION DE SURFACES LUMINEUSES ANALOGIQUES, ET PROCEDE DE FABRICATION**
ANIMATIONSVORRICHTUNG VON ANALOGEN LEUCHTFLÄCHEN, UND ENTSPRECHENDES HERSTELLUNGSVERFAHREN
DEVICE FOR ANIMATION OF ANALOGUE LIGHT SURFACES, AND METHOD FOR MANUFACTURING SAME

(43) Date de publication de la demande: 31.03.2021
(73) Titulaire: Univ Paris XIII Paris-Nord Villetaneuse, 93430 Villetaneuse (FR); Centre National de la Recherche Scientifique, 75016 Paris (FR)
(72) Inventeur: CHIME, Alex Chamberlain, 91100 Corbeil Essonnes (FR); SOLARD, Jeanne, 95170 Deuil-la-Barre (FR); OUIRIMI, Amani, 95880 Enghien les Bains (FR); CHAKAROUN, Mahmoud, 95170 Deuil-la-Barre (FR); LOGANATHAN, Nixson, 93800 Epinay sur Seine (FR); FISCHER, Alexis, 95550 Bessancourt (FR)
(74) Mandataire: A.P.I. Conseil

(56) Documents cités:
- US-A1- 2002 014 836

## Description

### DOMAINE DE L'INVENTION

La présente invention concerne le principe de conception et la réalisation d'afficheurs optoélectroniques organiques analogiques permettant des animations lumineuses simples avec des rendus esthétiques importants mais ne nécessitant qu'une complexité technologique limitée les rendant utilisables en signalétique et en packaging sur des objets embarqués éventuellement sur des substrats souples. Ces écrans analogiques sont fondés sur le principe des diodes électroluminescentes organiques.

### ETAT DE LA TECHNIQUE

Les matériaux organiques qui peuvent se décliner en matériaux polymères et en petites molécules ont la propriété de pouvoir être mis en couche mince par diverses méthodes ce qui permet un grand nombre d'applications (peintures, encres, évaporation). Parmi les matériaux organiques luminescents, on distingue les matériaux photoluminescences et les matériaux électroluminescents. Les matériaux électroluminescents peuvent se contenter d'une batterie et ne nécessitent pas une source lumineuse extérieure.

Parmi les technologies de l'optoélectronique organique basée sur les matériaux électroluminescents, les diodes électroluminescentes organiques (OLED) présentent des propriétés qui permettent de réaliser des surfaces lumineuses électroactives, ce qui les rendent intéressantes pour des applications dans le domaine de l'éclairage, de l'affichage et de la signalétique.

La signalétique est un domaine naissant qui emprunte aux domaines des écrans d'une part, et au domaine de l'éclairage d'autre part. Or, la signalétique possède des spécificités propres comme la nécessité d'un rendu esthétique avec des motifs fins et des animations, une simplicité technologique permettant une production en masse et à bas prix. Ceci nécessite donc des techniques spécifiques et adaptées qui restent à définir.

| Applications des OLEDs | Éclairage | Signalétique | écrans/Affichage |
|---|---|---|---|
| Intégration de motifs fins, de rendus esthétiques et d'animations | Non - | Oui + | Oui ++ |
| Complexité fabrication technologique de la | faible + | Faible à modérée + | importante +++ |
| Consommation électrique efficacité lumineuse (à comparable) | faible ++ | faible ++ | modérée - |

Les solutions d'éclairage OLED qui offrent des rendements et efficacité relativement bons s'approchant de ceux des LEDs présentent des coûts de production relativement élevés, comparativement à ces dernières notamment en raison du coût des matériaux et de la complexité technologique à mettre en oeuvre pour atteindre ces performances. Elles ne permettent pas d'inclure des motifs et des animations.

A noter que des performances en efficacité moindre devraient permettre de réduire leur coût de fabrication, mais ceci implique d'adresser un autre marché que l'éclairage.

Les objets technologiques fondés sur les OLEDs permettant d'afficher des animations lumineuses sont à ce jour:
- des afficheurs,
- des écrans à matrice passive,
- des écrans à matrice active.

Les afficheurs sont généralement limités à des segments permettant l'affichage de chiffres et incorporent des fonctions électroniques rudimentaires permettant leur pilotage, mais ils ne présentent pas un bon rendu esthétique ou un rendu esthétique adaptable à façon.

Les écrans à matrices passives ou à matrices actives sont constitués de pixels lumineux réguliers et de transistors permettant leur activation et le contrôle de leur intensité lumineuse. Le rendu esthétique et les animations sont sans limite. Des possibilités d'évoluer vers de l'interactivité existent. La complexité technologique est importante. Si l'efficacité lumineuse des pixels est bonne, la consommation électrique est partiellement réduite par l'électronique de contrôle.

US2002014836 A1, décrit un dispositif d'affichage électroluminescent organique utilisé comme dispositif d'affichage ou source lumineuse. Le dispositif permet de réaliser un allumage séquentiel de surfaces.

### EXPOSE DE L'INVENTION

La voie intermédiaire proposée dans ce brevet consiste à s'affranchir de la digitalisation (pixels) de l'écran et d'un maximum de son électronique de commande pour réaliser un objet technologiquement plus simple et plus rapide à fabriquer, à moindre coût et qui offre néanmoins une possibilité d'intégrer de façon prédéterminée un motif à façon avec une esthétique optimisée. On peut synthétiser le positionnement de la solution proposée ici par deux questions :
- A-t-on vraiment besoin d'un écran de smartphone pour faire de la signalétique lumineuse sur une bouteille d'eau minérale ?
- Peut-on faire de la signalétique électroluminescente avec panneau d'éclairage électroluminescent organique améliorée ?
Ici il est proposé un dispositif technologiquement simplifié qui emprunte aux panneaux d'éclairage OLED.

Un but de l'invention est de permettre de rendre l'illusion du mouvement dans des afficheurs fondée sur des diodes organiques électroluminescentes et destinée à la signalétique et au packaging lumineux.

L'intégration d'animations rudimentaires prédéfinies dans des dispositifs optoélectroniques organiques se fait en structurant des cathodes et des anodes.

Une première originalité consiste en une combinaison particulière de structuration d'anodes et de cathodes activée dans un ordre donnée pour donner illusion du mouvement.

Une deuxième originalité consiste à décomposée une seule cathode métallique (aluminium, Mg-Ag,...) en plusieurs zones par le biais d'une résine isolante préalablement déposée et dont le profil est inversé pour créer une discontinuité électrique favorable à la décomposition en zone.

Une troisième originalité est l'implantation de motifs et de nuance par le biais d'une résine isolante de faible épaisseur.

En d'autres termes, l'afficheur analogique animé est composé des couches suivantes, selon l'ordre de fabrication :
1. Un substrat transparent (rigide ou souple) à travers lequel la lumière sera émise.
2. Une couche transparente et conductrice faisant office d'anode (éventuellement structurée en plusieurs parties élémentaires suivant des formes géométriques prédéfinies) et à travers laquelle la lumière sera émise.
3. Une couche isolante définissant le contour du ou des motifs prédéterminés à implanter
4. Une couche ou un empilement à profil inversé permettant la séparation des cathodes
5. L'empilement des couches de la diode électroluminescente organique (typiquement 5 à 6 couches) déposée sur la quasi-intégralité de la surface.
6. Une couche (éventuellement métallique) déposée sur la quasi intégralité de la surface en une seule fois et jouant le rôle de cathode qui se retrouve subdivisée en plusieurs zones électriquement indépendante grâce à la couche 4 à profil inversée.

La présente invention permet notamment la fabrication d'étiquettes lumineuses animées a base de ces semi-conducteurs organiques électroluminescents. Ces étiquettes lumineuses, sont composées d'une OLED logotype animée, de son circuit de commande. Ses applications concernent l'étiquetage de bouteille (ou autre emballage) ou d'empaquetage.

L'OLED logotype est fabrique sur substrat de verre ou sur substrat souple, rapporté sur un flacon ou un autre emballage transparent ou directement sur le supporte transparent. Le circuit de commande intègre une source d'énergie électrique et un interrupteur et un circuit logique permettant de piloter différentes zones lumineuses du logotype.

Dans le cas de l'étiquetage de bouteille, la source d'énergie et le circuit électrique de commande peuvent être conditionnes dans un boitier qui sert de socle a la bouteille avec des connexions électriques vers le logotype. On pourrait également envisager une alimentation par batterie polymère-ion réalisée sur la face arrière de l'étiquette.

En particulier, l'invention concerne un dispositif d'animation de surfaces lumineuses analogiques, afin d'allumer séquentiellement des images pour réaliser visuellement un mouvement d'au moins un élément par commande électrique séquentielle, présentant :
- un dispositif organique optoélectronique du type OLED ayant des zones actives avec chacune un motif géométrique spécifique, sur un substrat transparent qui supporte :
   - une première couche formée de plusieurs anodes transparentes et conductrices, séparées latéralement par des gravures ;
   - une deuxième couche isolante sur des endroits de la première couche, servant à isoler électriquement les anodes et présentant une épaisseur e1 ;
   - une troisième couche d'une épaisseur e2 comportant au moins un empilement de couches organiques, les couches organiques qui sont en contact direct avec les anodes étant actives tandis que les couches organiques qui sont déposées sur la deuxième couche étant inertes ;
   - une quatrième couche métallique d'une épaisseur e3 présentant plusieurs cathodes séparées latéralement les unes des autres, et recouvrant ledit empilement de couches organiques,
   - des profils de séparation latérale des cathodes et des couches organiques, pour isoler électriquement les cathodes, d'épaisseur e4 supérieure à e1+e2+e3, déposés sur la première couche ou sur la deuxième couche,
      le recouvrement des anodes, de l'empilement de couches organiques, et des cathodes définissant des zones actives séparées, de façon à présenter en regard:
         - des anodes séparées et une cathode commune ;
         - des anodes séparées et des cathodes séparées ; et/ou
         - une anode commune et des cathodes séparées ;
      les gravures, les profils de séparation latérale et/ou la deuxième couche isolante permettant de réaliser les zones actives séparées latéralement, ayant chacune un motif géométrique spécifique,
- une alimentation électrique, des fils électriques et des contacts électriques reliés aux anodes et aux cathodes pour leur alimentation en tension de façon à permettre lors d'une séquence, l'allumage d'une ou de plusieurs zones actives séparées,
   par une combinaison : d'une ou de plusieurs anodes, et d'une ou de plusieurs cathodes ;
- reliés aux fils électriques, des moyens d'activation sélective et d'affichage des zones actives séparées latéralement, pour activer et afficher à chaque séquence une ou des zones actives séparées, et former séquentiellement des images animées.

Selon l'invention telle que revendiquée:
- les moyens d'activation sélective et d'affichage, sont configurés pour permettre d'afficher :
   une première image par l'activation d'au moins deux zones actives séparées, contiguës, activées par la combinaison:
      - d'une première anode et d'au moins une deuxième anode, et
      - d'une première cathode en regard de la première anode et de la deuxième anode, une deuxième image par l'activation d'au moins deux zones actives séparées, contiguës, activées par la combinaison :
      - de la première cathode et d'une deuxième cathode, et
      - de la deuxième anode en regard de la première cathode et de la deuxième cathode,
   l'une des deux zones actives activées dans cette deuxième image, étant activée dans la première image.

Selon d'autres caractéristiques avantageuses du dispositif:
- il a été réalisé par photolithographie et développement et la deuxième couche est une résine photosensible négative.
- les profils de séparation latérale sont réalisés par photolithographie et développement, et présentent :
   - un empilement de deux résines déposées l'une sur l'autre avec une résine non-photosensible déposée en contact avec la première couche ou la deuxième couche, et une résine photosensible positive sur la résine non-photosensible.
- les profils de séparation latérale ont une épaisseur au moins quatre fois supérieure à la somme des épaisseurs e1+e2+e3.
- les profils de séparation latérale ont des profils inversés dont la pointe est en contact de la première couche ou de la deuxième couche, et dont la base élargie par rapport à la pointe est située au-dessus de la quatrième couche.
- l'épaisseur des profils de séparation latérale est d'un à plusieurs micromètres.
- la deuxième couche isolante présente des colorants et/ou des quantums dots pour absorber la lumière émise par les zones actives séparées et réémettre de la lumière à une autre longueur d'onde visible.
- le dispositif micro-organique optoélectronique du type OLED présente un contour métallique et/ou des lignes métalliques pour augmenter la conductivité des anodes de la première couche.
- Il tel que :
   - les anodes sont en ITO (oxyde d'étain-indium) ;
   - l'empilement de couches organiques comporte : polymères, petites molécules, matériaux phosphorescents, matériaux activables thermiquement ; et
   - le substrat transparent est un substrat souple ou en verre, en silicium, en oxyde de silicium, en oxyde de silicium sur silicium, en polymère.
- les moyens d'activation sélective et d'affichage des zones actives séparées, sont : un circuit d'impulsions du type horloge ou bascule électrique (), avec une sortie positive et une sortie négative, des interrupteurs () commandés par le circuit d'impulsions et reliant des anodes et des cathodes à la source d'alimentation du type batterie ou accumulateur ou générateur.

L'invention concerne également un procédé de fabrication d'un dispositif organique optoélectronique du type OLED du dispositif d'animation de surfaces lumineuses analogiques selon l'invention, comprenant :
➢ la réalisation sur un substrat transparent des anodes, par:
   - dépôt d'une première couche transparente et conductrice sur le substrat transparent, formée de plusieurs anodes transparentes et conductrices, séparées latéralement par des gravures ;
   - structuration prédéfinie d'un motif géométrique spécifique pour chaque anode ;
> le dépôt d'une deuxième couche isolante sur des endroits de la première couche, servant à isoler électriquement les anodes et présentant une épaisseur e1 ;
> la réalisation de profils de séparation latérale d'épaisseur e4 ;
> le dépôt de la troisième couche de couches organiques d'épaisseur e2, par évaporation sur : les anodes séparées, la deuxième couche isolante, et les profils de séparation latérale ;
> le dépôt de la quatrième couche métallique d'épaisseur e3, par évaporation d'un métal sur les couches organiques et les profils de séparation latérale, pour réaliser les cathodes, qui sont séparées latéralement par les profils de séparation latérale,

l'épaisseur e4 étant supérieure à e1+e2+e3
le recouvrement des anodes, de l'empilement des couches organiques, et des cathodes définissant des zones actives séparées, de façon à présenter en regard:
   - des anodes séparées et une cathode commune ;
   - des anodes séparées et des cathodes séparées ; et/ou
   - une anode commune et des cathodes séparées ;
les gravures, les profils de séparation latérale et/ou la deuxième couche isolante permettant de réaliser les zones actives séparées, avec chacune un motif géométrique spécifique.

Selon des caractéristiques avantageuses du procédé :
- il comprend les étapes suivantes :
   ➢ pour la structuration des anodes :
      - dépôt d'une résine photosensible sur la première couche ;
      - positionnement d'un masque de photolithographie dont les ouvertures permettent la structuration prédéfinie d'un motif géométrique spécifique pour chaque anode, sur la résine photosensible ;
      - photolithographie par insolation de la résine photosensible à travers les premières ouvertures, développement, gravure dans la première couche pour réaliser les anodes séparées et nettoyage de la résine ;
   ➢ pour le dépôt de la deuxième couche isolante :
      - dépôt d'une deuxième couche isolante comprenant une résine photosensible d'épaisseur e1 sur les anodes séparées constituant la première couche ;
      - positionnement d'un masque de photolithographie ;
      - photolithographie par insolation et développement de la deuxième couche isolante;
   ➢ pour la réalisation de profils de séparation latérale :
      - dépôt d'au moins une résine photosensible sur les anodes et la deuxième couche isolante ;
      - positionnement d'un masque de photolithographie dont les ouvertures permettent de réaliser les profils de séparation latérale ;
      - photolithographie par insolation UV et développement de la résine photosensible pour réaliser les profils de séparation latérale.
- avant le dépôt de la deuxième couche isolante sur la première couche, on réalise les étapes suivantes :
   - dépôt d'une couche de résine photosensible sur les anodes ;
   - positionnement d'un masque de photolithographie dont les ouvertures définissant les endroits où sera déposée une couche métallique pour réaliser un contour métallique et/ou des lignes métalliques ;
   - photolithographie par insolation de la couche de résine photosensible positive à travers les ouvertures, et développement ;
   - dépôt de la couche métallique de telle sorte que les endroits des anodes non recouverts de la deuxième couche soient recouvertes de la couche métallique en contact direct avec la première couche ;
   - nettoyage de la couche de résine photosensible pour l'enlever.
- avant le dépôt de la résine photosensible sur les anodes et/ou sur la deuxième couche isolante, on dépose une résine non photosensible sur cette résine photosensible, pour réaliser des profils de séparation latérale inversés qui présentent :
   - une pointe qui est en contact de la couche formée de plusieurs anodes séparées, et
   - une base élargie par rapport à la pointe et située au-dessus de la couche formée des cathodes séparées.
- il est tel que :
   - la résine photosensible déposée sur la première couche est positive ou négative,
   - la résine photosensible formant la deuxième couche est négative, et
   - la résine photosensible pour réaliser les profils de séparation latérale est positive.
- les ouvertures du deuxième masque sont disposées sur la deuxième couche isolante, pour que la photolithographie et gravure de la deuxième couche isolante laissent les espaces séparant les anodes remplis par la deuxième couche isolante.
- la première couche est une couche d'ITO pour réaliser les anodes, et dans lequel de l'aluminium ou de l'or-chrome est déposé par évaporation pour réaliser les cathodes.

### DESCRIPTION DES FIGURES

D'autres objectifs, caractéristiques et avantages sortiront de la description détaillée qui suit en référence aux dessins donnés à titre illustratif et non limitatif parmi lesquels :
- la figure 1 représente la décomposition du logotype en images statiques et en motifs ;

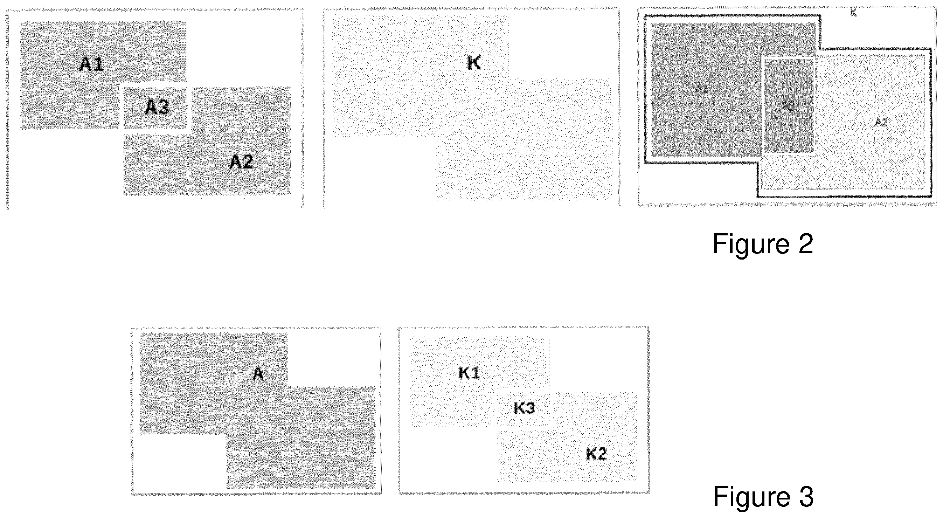

- la figure 2 représente le partitionnement de l'anode à gauche, au milieu une cathode et à droite la structure complète ;
- la figure 3 représente une anode commune à gauche, et 3 cathodes séparées à droite ;
- la figure 4 représente un point d'étranglement et le partitionnement de l'anode et de la cathode ;
- la figure 5 représente une vue en coupe de l'OLED lumineuse animée avec métallisation selon un premier mode de réalisation possible de l'invention ;
- la figure 6 représente une vue en coupe de l'OLED lumineuse animée sans métallisation selon un second mode de réalisation possible de l'invention ;
- la figure 7 représente les étapes de réalisation sur un substrat transparent des anodes ;
- la figure 8 représente l'étape de métallisation sur certaines zones des anodes ;
- la figure 9 représente l'étape de dépôt d'une deuxième couche isolante sur des zones des anodes ;
- la figure 10 représente l'étape de réalisation de profils de séparation latérale ;
- la figure 11 représente l'étape de dépôt de couches organiques d'épaisseur, par évaporation sur: les anodes séparées, la deuxième couche isolante, et les profils de séparation latérale ;
- la figure 12 représente l'étape de dépôt de la quatrième couche métallique, par évaporation d'un métal sur les couches organiques et les profils de séparation latérale, pour réaliser les cathodes, qui sont séparées latéralement par les profils de séparation latérale ;

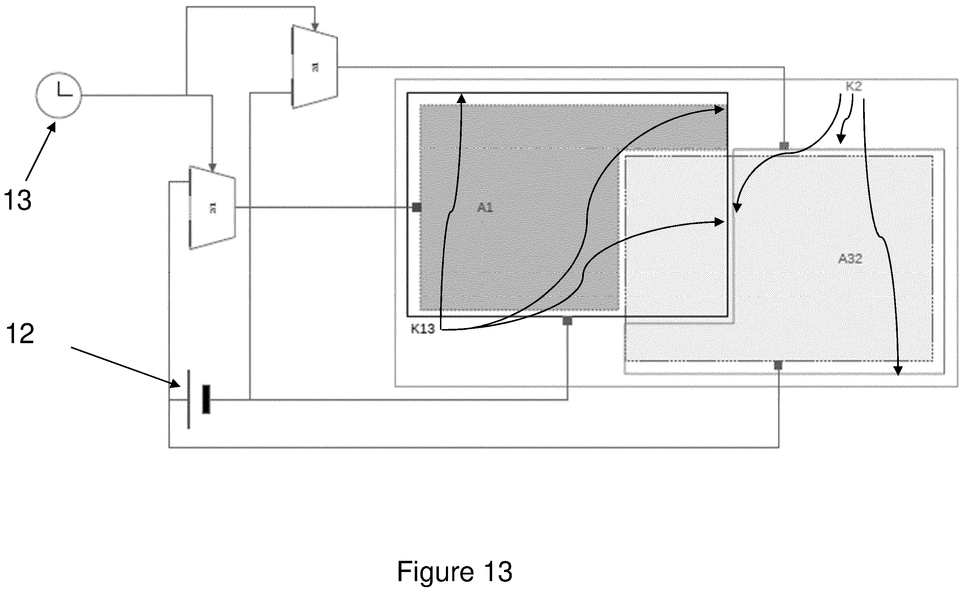

- la figure 13 représente le schéma électrique d'alimentation avec un circuit de commande ;

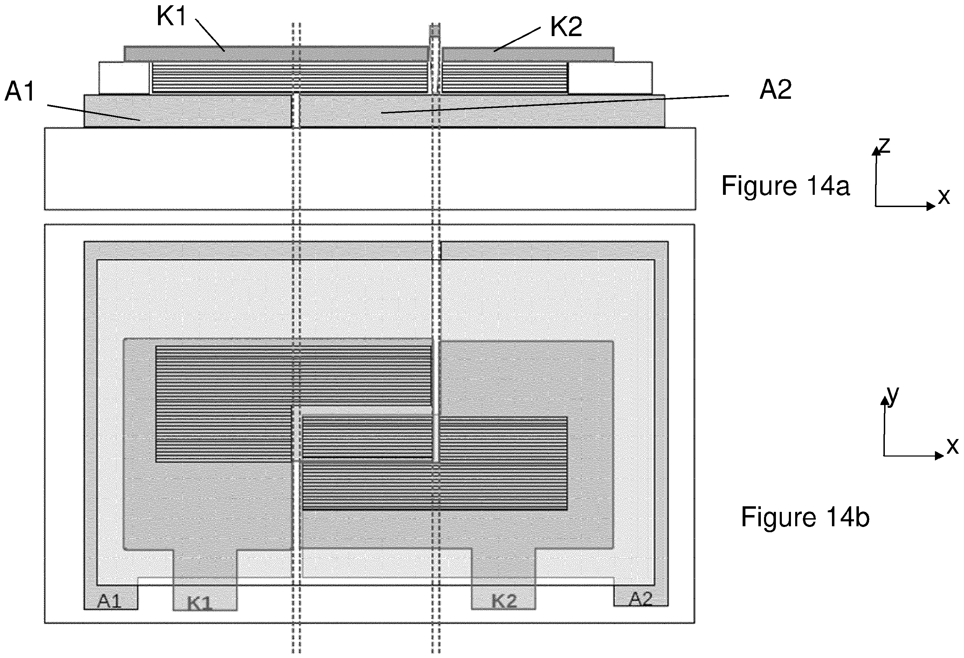

- la figure 14a et 14b représentent respectivement une vue de coupe et une vue du dessus du dispositif selon l'invention avec les anodes séparées A1, A2 et les cathodes séparées K1, K2 ;
- la figure 15 représente un schéma fonctionnel électrique pour animer une OLED ;

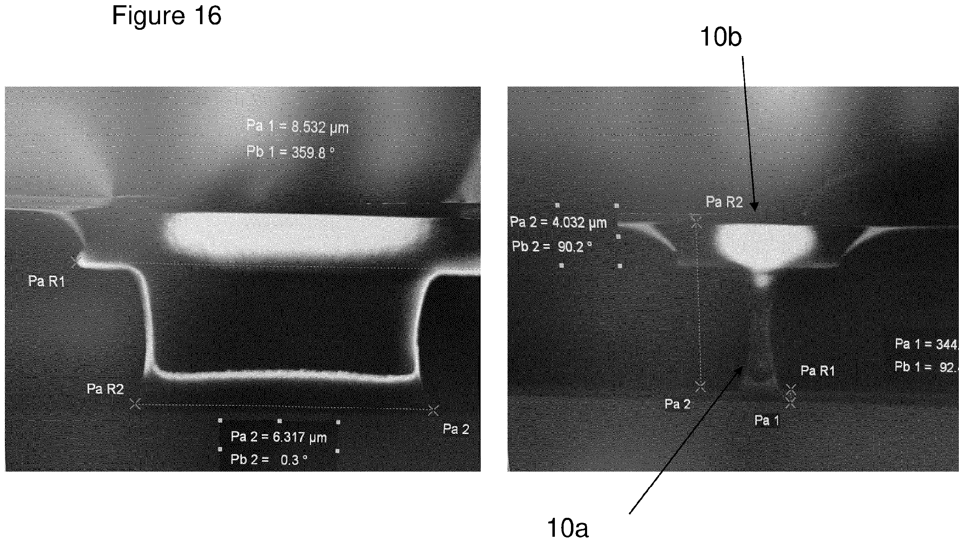

- les figures 16 représente des images obtenues à partir du microscope à balayage électronique de l'étape de réalisation de profils de séparation latérale ;

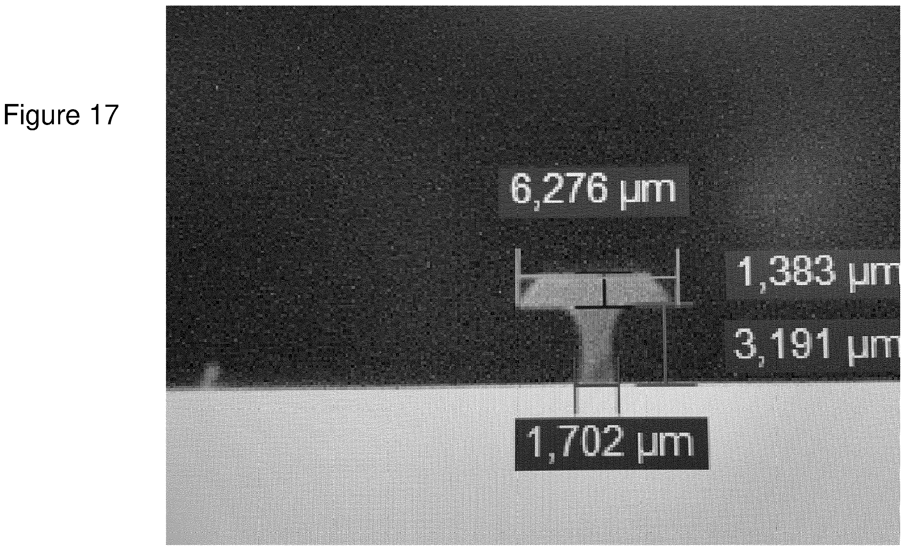

- la figure 17 représente une image obtenue à partir du microscope optique de l'étape de réalisation des profils de séparation latérale ;

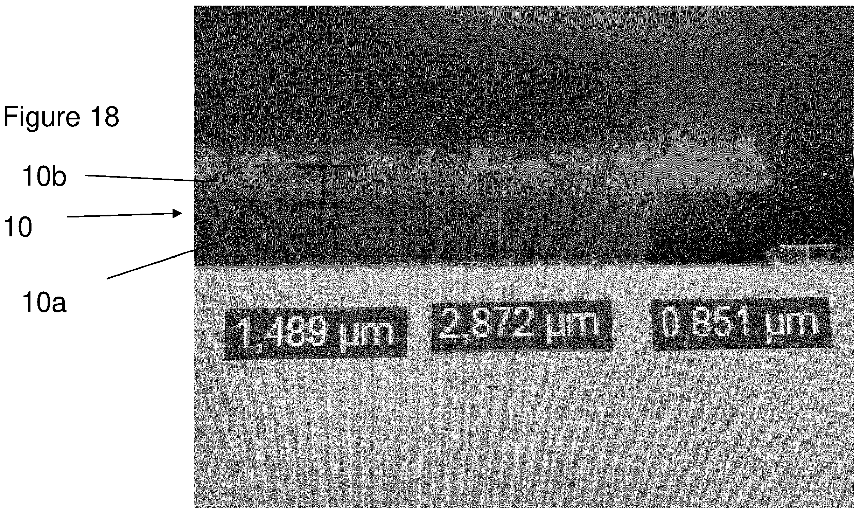

- la figure 18 représente une image obtenue à partir du microscope optique après l'étape de dépôt des couches organiques et de la couche métallique.

### DESCRIPTION DETAILLEE DE L'INVENTION

La présente invention concerne un dispositif d'animation de surfaces lumineuses analogiques, afin d'allumer séquentiellement des images pour réaliser visuellement un mouvement d'au moins un élément par commande électrique séquentielle.

Ce dispositif utilise un principe similaire à celui d'un folioscope. Il s'agit de la représentation d'un objet animé, dont le mouvement est décomposé chronologiquement en une succession d'images, dont l'affichage rapide procure à l'oeil l'illusion que l'objet bouge.

Pour simplifier la fabrication au maximum, les inventeurs n'ont pas utilisé les techniques classiques de digitalisation de l'écran par pixels dans lesquelles il faut activer à la suite plusieurs pixels pour allumer une zone.

A la place, et par esprit de simplification, les inventeurs ont défini des motifs « analogiques » par structuration prédéfinie de formes géométriques plus ou moins complexes.

On peut alors structurer des motifs dans l'OLED de différentes façons, soit au niveau de l'anode, soit au niveau de la cathode, soit par une combinaison des deux pour donner :
- anode commune - cathodes séparées :
- anodes séparées - cathode commune
- combinaison

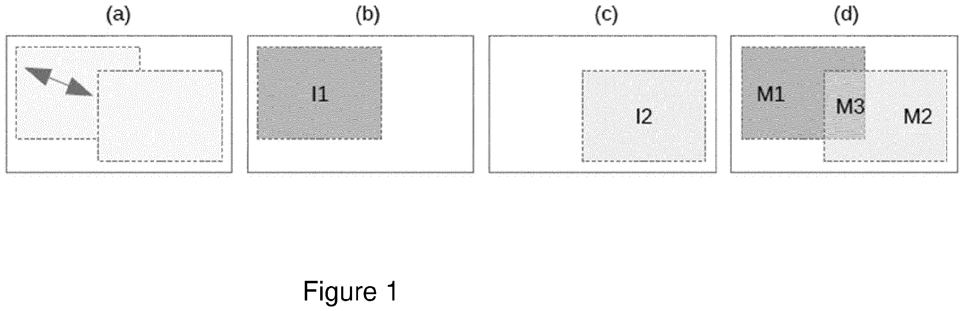

En guise d'illustration, considérons un logotype animé représentant un rectangle dont on cherche à rendre l'illusion du déplacement entre deux positions (Figure 1.a). Il peut être décomposé en une succession de deux images statiques I1 et I2 s'allumant alternativement pour créer un effet d'animation.

Dans un souci de clarté dans la démarche de réalisation du logotype, chacune des images est représentée dans une couleur différente sur les figures (1.b) et (1.c) ci-après. En superposant les deux images, les combinaisons de couleurs dans l'image résultante permettent de définir trois motifs distincts M1 (₌ I1 sans I2), M2(=I2 sans I1) et M3 (l'intersection des deux images I1 et I2) sur la figure (1.d), chacun identifiable par une couleur différente.

La problématique principale consiste alors à mettre en oeuvre le partitionnement de différentes zones à travers un choix judicieux des combinaisons cathodes / anodes qui permettent d'allumer une zone plutôt qu'une autre. Avec l'idée de l'animation analogique que les chercheurs proposent ici, le partitionnement peut être mis en oeuvre de 3 façons:

### 1. Anodes séparées - Cathode commune

Les motifs sont définis en découpant l'anode en plusieurs zones séparées électriquement les unes des autres.

Cette séparation s'obtient par exemple par gravures de la couche transparente et conductrice d'ITO.

Dans le cas de l'exemple ci-avant, le report des trois motifs par gravure dans l'anode donne trois contacts A1, A2 et A3, respectivement, par lesquelles il est possible d'allumer l'image voulue I1 ou I2.

Pour l'image I1, on doit venir chercher les contacts A1+A3 et la cathode commune K, et pour l'image I2 ce sera le tour des anodes A2+A3 et la cathode commune K.

### 2. Anodes communes, cathodes séparées

Dans cette configuration, les images finales ne sont pas implémentées par des zones différentes au niveau de l'anode transparente et conductrice, mais par des cathodes différentes K1, K2, K3. La difficulté est importante pour partitionner les cathodes en raison du procédé de fabrication même des OLEDs.

### 3. Anodes séparées - Cathodes séparées (définition des motifs conjointement par l'anode et la cathode)

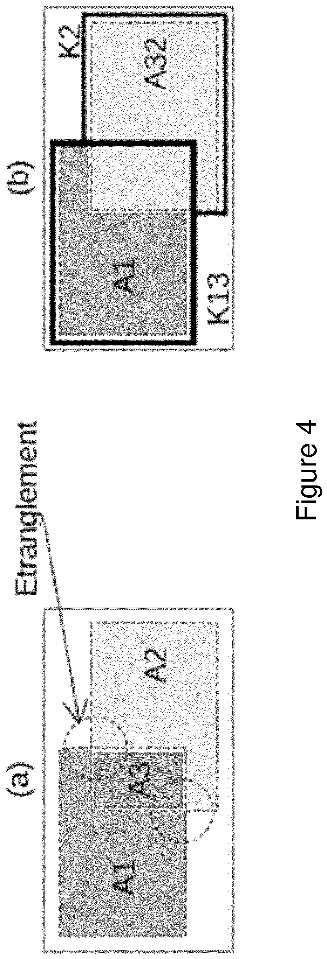

L'approche « anodes séparées » peut montrer des limites dans certains cas particuliers, notamment lorsque certains motifs sont quasiment imbriqués dans d'autres, et que la prise de contacts électriques vers la source d'excitation est difficile. Dans l'exemple, deux points d'étranglement, voir figure 4a, sont susceptibles d'induire une forte résistance de contact en cas de gravure dans l'ITO, rendant ainsi difficile ou peu efficace la prise avec A3. Cela peut se traduire par des différences de luminosité des zones A2 par rapport à A1 ou A3.

Dans de tel cas, une alternative consiste à redistribuer les motifs en renvoyant d'autres motifs sur plusieurs cathodes, voir figure 4b. On peut par exemple reporter les motifs M1 et (M3+M2) dans l'anode à travers deux contacts A1 et A32, puis les motifs (M1+M3) et M2 dans la cathode à travers deux contacts de cathode K13 et K2. Des lignes de résine structurées en profil casquette permettent alors de partitionner la cathode, ce qui correspond à l'objet de la présente invention.

Il est alors possible d'allumer l'image I1 en prenant les deux contacts d'anode A1, A32 et la cathode K13 ; et pour l'image I2, ce sera la combinaison de l'anode A32 avec les deux cathodes K13 et K2.

Une autre alternative au problème d'étranglement ou de motif imbriqué est d'imprimer sur les motifs d'anode des filets de très fines pistes conductrices de métal noble comme l'or par exemple.

On améliore ainsi l'injection de courant et sa circulation tant à l'intérieur des motifs que sur les points d'étranglement.

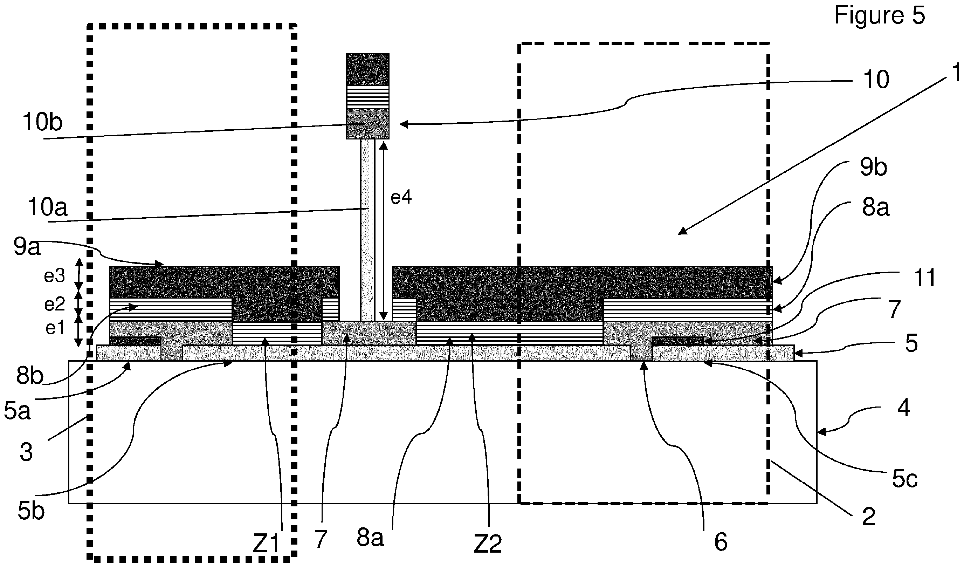

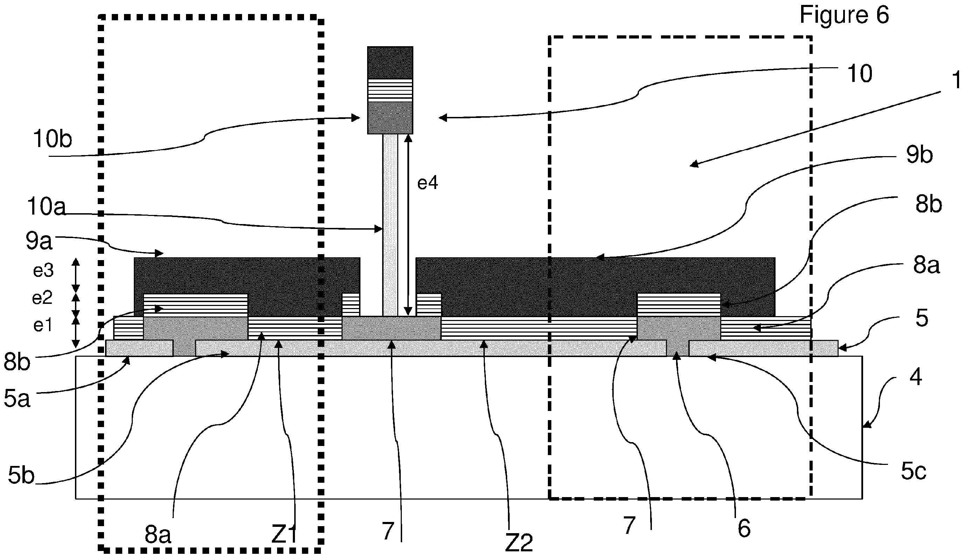

Le principe de l'empilement sur lequel est fondé ce dispositif 1 est représenté sur les figures 5 et 6.

On y distingue les zones actives Z1, Z2 qui sont composées d'une anode, d'empilement de couches organiques, et d'une cathode.

On y distingue deux parties offrant deux types de fonctionnement :
- Une partie 2 à anodes séparées et cathode commune.
- Une partie 3 à anode commune et cathodes séparées.

L'activation en alternance des sites lumineux entre ces deux parties 2 et 3 permet de générer l'illusion du mouvement.

Plus précisément, comme illustré sur les figures 5 et 6, le dispositif d'animation est un dispositif organique optoélectronique 1du type OLED ayant des zones actives Z1, Z2 avec chacune un motif géométrique spécifique, sur un substrat transparent 4 qui supporte :
> des couches d'empilement dans l'ordre suivant:
   - une première couche 5 formée de plusieurs anodes 5a, 5b, 5c transparentes et conductrices, séparées latéralement par des gravures 6 ;
   - une deuxième couche isolante 7 sur des zones de la première couche 5, servant à isoler électriquement les anodes 5a, 5b, 5c et présentant une épaisseur e1 ;
   - une troisième couche 8 d'une épaisseur e2 comportant au moins un empilement de couches organiques, les couches organiques 8a qui sont en contact direct avec les anodes 5a, 5b, 5c étant actives tandis que les couches organiques 8b qui sont déposées sur la deuxième couche étant inertes ;
   - une quatrième couche métallique 9 d'une épaisseur e3 présentant plusieurs cathodes 9a, 9b séparées latéralement les unes des autres, et recouvrant ledit empilement de couches organiques 8.

Conformément à la présente invention, le dispositif organique optoélectronique 1 du type OLED comporte des profils de séparation latérale 10 des cathodes 9a, 9b et des couches organiques 8, pour isoler électriquement les cathodes 9a, 9b, d'épaisseur e4 supérieure à e1+e2+e3, déposés sur la première couche 5 ou sur la deuxième couche isolante 7.

Le recouvrement des anodes 5a, 5b, 5c, des couches organiques, et des cathodes 9a, 9b définit des zones actives Z1, Z2 séparées, de façon à présenter en regard:
- des anodes 5a, 5b séparées et une cathode commune 9a ;
- des anodes séparées et des cathodes séparées ; et/ou
- une anode commune 5b et des cathodes 9a, 9b séparées;
les gravures 6, les profils de séparation latérale 10 et/ou la deuxième couche isolante 7 permettant de réaliser les zones actives Z1, Z2 séparées latéralement, ayant chacune un motif géométrique spécifique.

Les anodes 5a, 5b, 5c peuvent être en ITO (oxyde d'étain-indium).

L'empilement des couches organiques 8 peut comporter : polymères, petites molécules, matériaux phosphorescents, matériaux activables thermiquement ...

Le métal déposé par évaporation pour réaliser les cathodes 9a, 9b est de l'aluminium ou de l'or-chrome pour améliorer l'adhérence.

Le substrat transparent 4 peut être un substrat souple ou en verre, en silicium, en oxyde de silicium, en oxyde de silicium sur silicium, en polymère.

Avantageusement, dans un mode de réalisation préféré, le dispositif selon l'invention est réalisé par photolithographie et développement. Dans un autre mode de réalisation, le dispositif selon l'invention est réalisé par impression type, offset, rotative,...

Avantageusement, la deuxième couche isolante 7 présente des colorants et/ou des quantums dots pour absorber la lumière émise par les zones actives Z1, Z2 séparées, adjacentes à la deuxième couche isolante 7, et ré-émettre de la lumière à une autre longueur d'onde visible.

Avantageusement, le dispositif micro-organique optoélectronique du type OLED présente un contour métallique et/ou des lignes métalliques 11 pour augmenter la conductivité des anodes 5a, 5b, 5c de la première couche 5.

Dans le cas où le dispositif selon l'invention est réalisé par photolithographie et développement, la deuxième couche 7 est une résine photosensible négative.

Les profils de séparation latérale 10 peuvent présenter un empilement de deux résines déposées l'une sur l'autre avec une résine non-photosensible 10a déposée en contact avec la première couche 5 ou la deuxième couche, et une résine photosensible positive 10b sur la résine non-photosensible 10a.

Dans une réalisation, les profils de séparation latérale 10 ont une épaisseur au moins quatre fois supérieure à la somme des épaisseurs e1+e2+e3.

Avantageusement, comme illustré figures 5 et 6, les profils de séparation latérale 10 ont des profils inversés dont la pointe est en contact de la première couche 5 ou de la deuxième couche, et dont la base élargie par rapport à la pointe est située au-dessus de la quatrième couche, par exemple de forme tronconique.

L'épaisseur des profils de séparation latérale 10 peut être d'un à plusieurs micromètres.

Le dispositif organique optoélectronique 1du type OLED comporte aussi une alimentation électrique 12, des fils électriques et des contacts électriques reliés aux anodes 5a, 5b, 5c et aux cathodes 9a, 9b pour leur alimentation en tension de façon à permettre à chaque séquence, l'allumage d'une ou de plusieurs zones actives Z1, Z2 séparées, par une combinaison : d'une ou de plusieurs anodes 5a, 5b, 5c, et d'une ou de plusieurs cathodes 9a, 9b.

Le dispositif organique optoélectronique 1du type OLED comporte aussi reliés aux fils électriques, des moyens d'activation sélective et d'affichage 13 des zones actives Z1, Z2 séparées latéralement, pour allumer à chaque séquence une ou des zones actives Z1, Z2 séparées, et former séquentiellement des images animées.

Les moyens d'activation sélective et d'affichage 13, sont configurés pour permettre d'allumer :
une première image par l'activation d'au moins deux zones actives Z1, Z2 séparées, contiguës, activées par la combinaison:
   - d'une première anode et d'au moins une deuxième anode, et
   - d'une première cathode en regard de la première anode et de la deuxième anode,
une deuxième image par l'activation d'au moins deux zones actives Z1, Z2 séparées, contiguës,
activées par la combinaison :
   - de la première cathode et d'une deuxième cathode, et
   - de la deuxième anode en regard de la première cathode et de la deuxième cathode,
l'une des deux zones actives Z1, Z2 activées dans cette deuxième image, étant activée dans la première image.

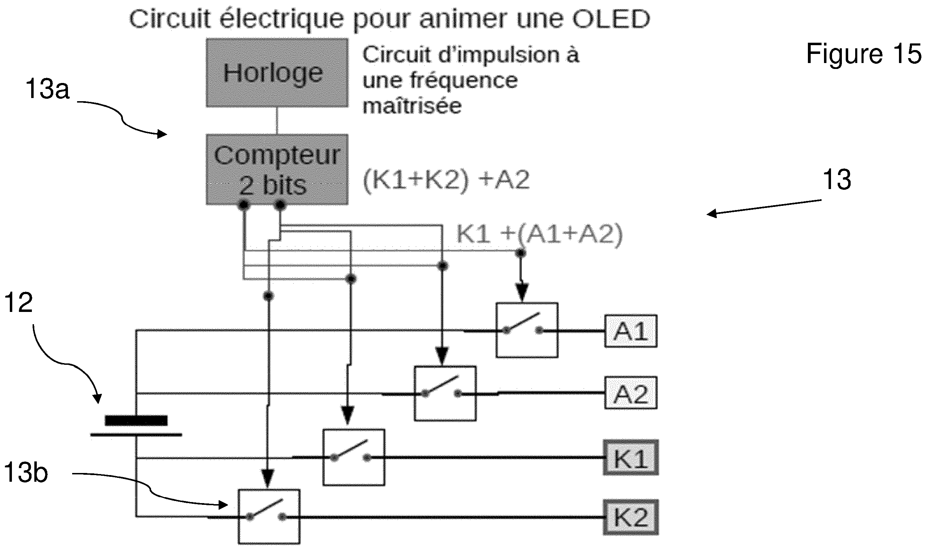

Comme illustré sur la figure 15, les moyens d'activation sélective et d'affichage 13 des zones actives Z1, Z2 séparées, sont : un circuit d'impulsions du type horloge ou bascule électrique 13a, avec une sortie positive et une sortie négative, des interrupteurs 13b commandés par le circuit d'impulsions et reliant des anodes 5a, 5b, 5c et des cathodes 9a, 9b à la source d'alimentation du type batterie ou accumulateur ou générateur.

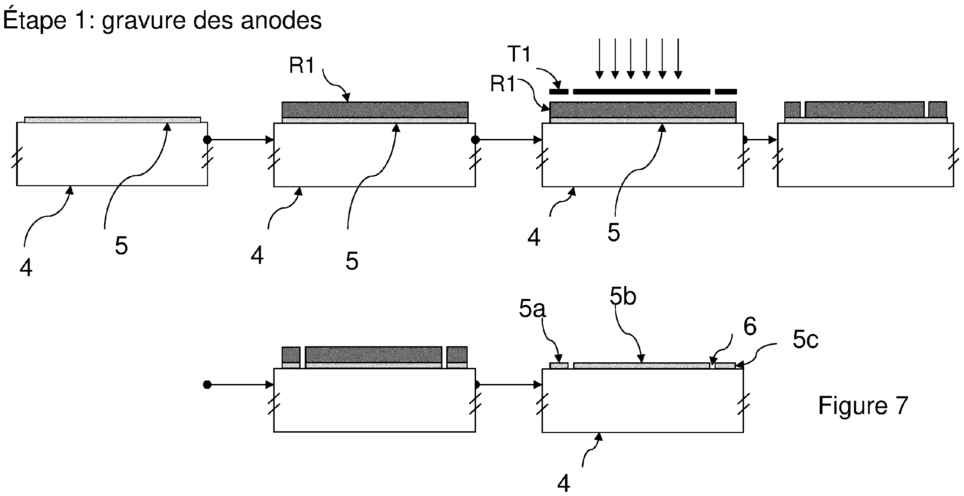

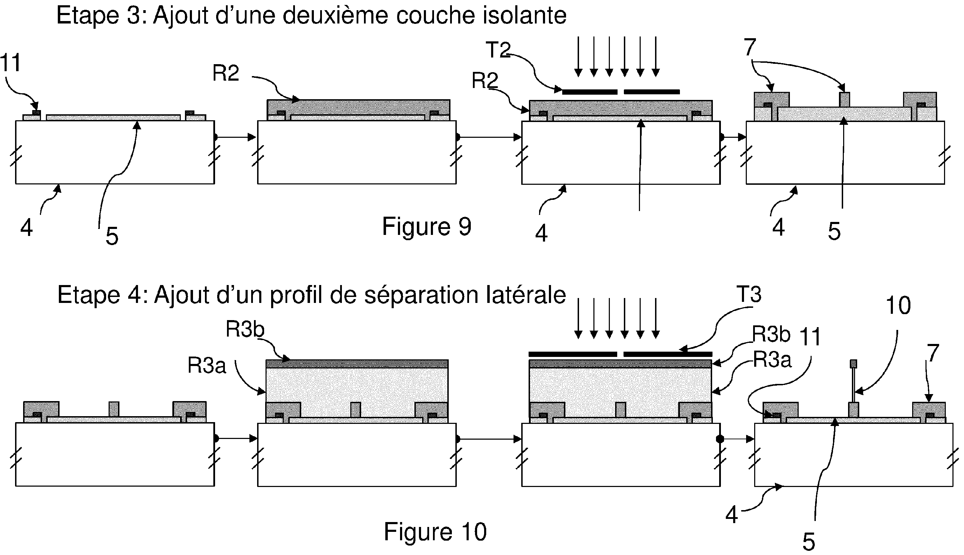

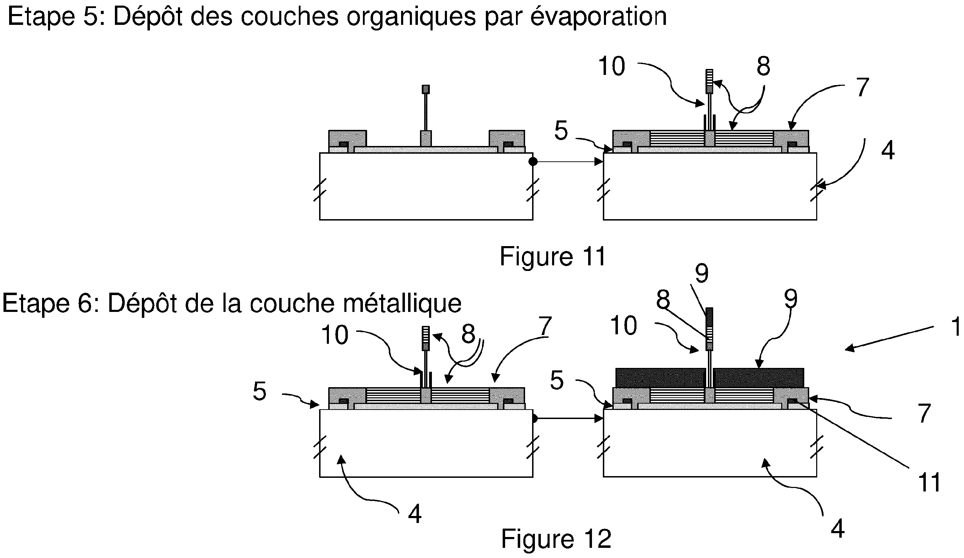

La présente invention concerne un procédé de fabrication du dispositif organique optoélectronique 1 comprenant :
> la réalisation sur un substrat transparent 4 des anodes 5a, 5b, 5c tel qu'illustré figure 7 par:
   - dépôt de la première couche 5 transparente et conductrice sur le substrat transparent 4, formée de plusieurs anodes 5a, 5b, 5c transparentes et conductrices, séparées latéralement par des gravures 6 ;
   - structuration prédéfinie d'un motif géométrique spécifique pour chaque anode ;
➢ le dépôt de la deuxième couche isolante 7 sur des zones de la première couche 5 tel qu'illustré figure 9, servant à isoler électriquement les anodes 5a, 5b, 5c et présentant une épaisseur e1;
➢ la réalisation des profils de séparation latérale 10 d'épaisseur e4, tel qu'illustré figure 10 :
   ➢ le dépôt de la troisième couche 8 de couches organiques d'épaisseur e2 tel qu'illustré figure 11, par évaporation sur : les anodes 5a, 5b, 5c séparées, la deuxième couche isolante 7, et les profils de séparation latérale 10 ;
   > le dépôt de la quatrième couche métallique 9 d'épaisseur e3 tel qu'illustré figure 12, par évaporation d'un métal sur les couches organiques et les profils de séparation latérale 10, pour réaliser les cathodes 9a, 9b, qui sont séparées latéralement par les profils de séparation latérale 10.

Comme les profils de séparation latérale 10 sont réalisés avant les dépôts de la troisième couche 8 et de la couche métallique 9, ces dernières sont représentées sur la partie supérieure des profils de séparation latérale 10 sur l'ensemble des figures 5, 6 et 12.

Avantageusement, le procédé de fabrication utilise la photolithographie et gravure, et comporte les étapes suivantes comme décrit dans les figures 7, 9, 10, 11 et 12 :
➢ pour la structuration des anodes 5a, 5b, 5c, tel qu'illustré figure 7 :
   - dépôt d'une résine photosensible R1 sur la première couche 5 ; cette résine photosensible R1 est positive ou négative ;
   - positionnement d'un masque de photolithographie T1 dont les ouvertures permettent la structuration prédéfinie d'un motif géométrique spécifique pour chaque anode, sur la première résine photosensible ;
   - photolithographie par insolation de la résine photosensible à travers les premières ouvertures, développement, gravure dans la première couche 5 pour réaliser les anodes 5a, 5b, 5c séparées et nettoyage de la résine ;
➢ pour le dépôt de la deuxième couche isolante 7, tel qu'illustré figure 9 :
   - dépôt d'une deuxième couche isolante 7 comprenant une résine photosensible R2 d'épaisseur e1 sur les anodes 5a, 5b, 5c séparées constituant la première couche 5; la résine photosensible formant la deuxième couche est négative
   - positionnement d'un masque de photolithographie T2 ;
   - photolithographie par insolation et développement de la deuxième couche isolante 7;
➢ pour la réalisation de profils de séparation latérale 10, tel qu'illustré figure 10 :
   - dépôt d'au moins une résine photosensible R3 sur les anodes 5a, 5b, 5c et la deuxième couche isolante 7; avantageusement, la résine photosensible pour réaliser les profils de séparation latérale 10 est positive
   - positionnement d'un masque de photolithographie T3 dont les ouvertures permettent de réaliser les profils de séparation latérale 10 ;
   - photolithographie par insolation UV et développement de la résine photosensible pour réaliser les profils de séparation latérale 10.

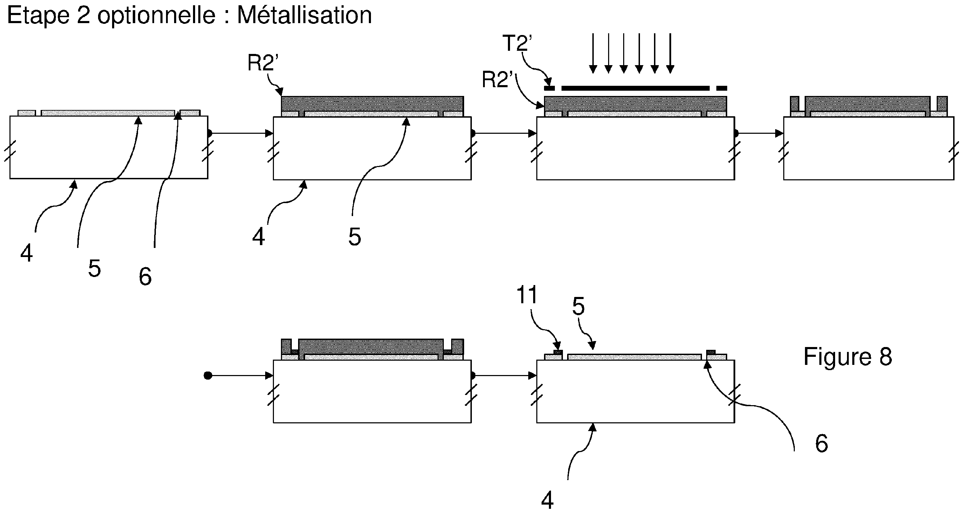

Avantageusement, comme décrit dans l'étape optionnelle 2 de la figure 8, on réalise les étapes suivantes dans lequel avant le dépôt de la deuxième couche isolante 7 sur la première couche 5, pour métalliser :
- dépôt d'une couche de résine photosensible R2' sur les anodes 5a, 5b, 5c;
- positionnement d'un masque de photolithographie T2' dont les ouvertures définissant les endroits où sera déposée une couche métallique pour réaliser un contour métallique et/ou des lignes métalliques 11 ;
- photolithographie par insolation de la couche de résine photosensible positive à travers les ouvertures, et développement ;
- dépôt de la couche métallique de telle sorte que les zones des anodes 5a, 5b, 5c non recouvertes de la deuxième couche soient recouvertes de la couche métallique en contact direct avec la première couche 5 ;
- nettoyage de la couche de résine photosensible pour l'enlever.

Avantageusement, comme représenté sur les figures 5, 6, 10, on dépose une résine non photosensible R3a, puis la résine photosensible R3b, pour réaliser des profils de séparation latérale 10 inversés qui présentent une pointe P qui est en contact de la couche formée de plusieurs anodes 5a, 5b, 5c séparées et une base B élargie par rapport à la pointe P qui est située au-dessus de la couche formée de plusieurs cathodes 9a, 9b séparées.

Dans une réalisation, les ouvertures sont disposées sur la deuxième couche isolante 7, pour que la photolithographie et gravure de la deuxième couche isolante 7 à travers les ouvertures du deuxième masque permettent de remplir les espaces séparant les anodes 5a, 5b, 5c, par la deuxième couche isolante 7.

Quelques ordres de grandeur peuvent être donnés à titre uniquement illustratifs et non limitatifs :
- les profils de séparation latérale 10 peuvent être de 4 micromètres ;
- la couche métallique de 150 nm ;
- la superposition de couches organiques de 60-120 nm ;
- la couche isolante de 300 nm ;
- la couche conductrice et transparente des anodes 5a, 5b, 5c séparées de 100 nm ;
- le substrat de 0,7 mm.

## Revendications

1. Dispositif d'animation de surfaces lumineuses analogiques, afin d'allumer séquentiellement des images pour réaliser visuellement un mouvement d'au moins un élément par commande électrique séquentielle,
présentant :
• un dispositif organique optoélectronique du type OLED (1) ayant des zones actives (Z1, Z2) avec chacune un motif géométrique spécifique, sur un substrat transparent (4) qui supporte :
- une première couche (5) formée de plusieurs anodes (5a, 5b, 5c) transparentes et conductrices, séparées latéralement par des gravures (6) ;
- une deuxième couche isolante (7) sur des endroits de la première couche (5), servant à isoler électriquement les anodes (5a, 5b, 5c) et présentant une épaisseur e1 ;
- une troisième couche (8) d'une épaisseur e2 comportant au moins un empilement de couches organiques, les couches organiques (8a) qui sont en contact direct avec les anodes (5a, 5b, 5c) étant actives tandis que les couches organiques (8b) qui sont déposées sur la deuxième couche étant inertes ;
- une quatrième couche métallique (9) d'une épaisseur e3 présentant plusieurs cathodes (9a, 9b) séparées latéralement les unes des autres, et recouvrant ledit empilement de couches organiques (8),
- des profils de séparation latérale (10) des cathodes (9a, 9b) et des couches organiques (8), pour isoler électriquement les cathodes (9a, 9b), d'épaisseur e4 supérieure à e1+e2+e3, déposés sur la première couche (5) ou sur la deuxième couche (7),
le recouvrement des anodes (5a, 5b, 5c), de l'empilement de couches organiques (8), et des cathodes (9a, 9b) définissant des zones actives (Z1, Z2) séparées, de façon à présenter en regard:
- des anodes (5a, 5b) séparées et une cathode commune (9a) ;
- des anodes séparées et des cathodes séparées ; et/ou
- une anode commune (5b) et des cathodes (9a, 9b) séparées;
les gravures (6), les profils de séparation latérale (10) et/ou la deuxième couche isolante (7) permettant de réaliser les zones actives (Z1, Z2) séparées latéralement, ayant chacune un motif géométrique spécifique,
• une alimentation électrique (12), des fils électriques et des contacts électriques reliés aux anodes (5a, 5b, 5c) et aux cathodes (9a, 9b) pour leur alimentation en tension de façon à permettre lors d'une séquence, l'allumage d'une ou de plusieurs zones actives (Z1, Z2) séparées,
par une combinaison : d'une ou de plusieurs anodes (5a, 5b, 5c), et d'une ou de plusieurs cathodes (9a, 9b);
• reliés aux fils électriques, des moyens d'activation sélective et d'affichage (13) des zones actives (Z1, Z2) séparées latéralement, pour activer et afficher à chaque séquence une ou des zones actives (Z1, Z2) séparées, et former séquentiellement des images animées,
les moyens d'activation sélective et d'affichage (13) étant en outre configurés pour permettre d'afficher :
une première image par l'activation d'au moins deux zones actives (Z1, Z2) séparées, contiguës, activées par la combinaison:
• d'une première anode et d'au moins une deuxième anode, et
• d'une première cathode en regard de la première anode et de la deuxième anode,
une deuxième image par l'activation d'au moins deux zones actives (Z1, Z2) séparées, contiguës, activées par la combinaison :
• de la première cathode et d'une deuxième cathode, et
• de la deuxième anode en regard de la première cathode et de la deuxième cathode,
l'une des deux zones actives (Z1, Z2) activées dans cette deuxième image, étant activée dans la première image.

2. Dispositif selon la revendication précédente, réalisé par photolithographie et développement et dans lequel la deuxième couche (7) est une résine photosensible négative.

3. Dispositif selon l'une des revendications précédentes, dans lequel les profils de séparation latérale (10) sont réalisés par photolithographie et développement, et présentent :
- un empilement de deux résines déposées l'une sur l'autre avec une résine non-photosensible (10a) déposée en contact avec la première couche (5) ou la deuxième couche (7), et une résine photosensible (10b) positive sur la résine non-photosensible (10a).

4. Dispositif selon l'une des revendications précédentes 1 à 3, dans lequel les profils de séparation latérale (10) ont une épaisseur au moins quatre fois supérieure à la somme des épaisseurs e1+e2+e3.

5. Dispositif selon l'une des revendications précédentes 1 à 4, dans lequel les profils de séparation latérale (10) ont des profils inversés dont la pointe (P) est au contact de la première couche (5) ou de la deuxième couche (7), et dont la base (B) élargie par rapport à la pointe (P) est située au-dessus de la quatrième couche (9).

6. Dispositif selon l'une des revendications précédentes, dans lequel l'épaisseur des profils de séparation latérale (10) est d'un à plusieurs micromètres.

7. Dispositif selon l'une des revendications précédentes, dans lequel la deuxième couche isolante (7) présente des colorants et/ou des quantums dots pour absorber la lumière émise par les zones actives (Z1, Z2) séparées et réémettre de la lumière à une autre longueur d'onde visible.

8. Dispositif selon l'une des revendications précédentes, dans lequel le dispositif micro-organique optoélectronique du type OLED présente un contour métallique et/ou des lignes métalliques (11) pour augmenter la conductivité des anodes (5a, 5b, 5c) de la première couche (5).

9. Dispositif selon l'une des revendications précédentes, dans lequel :
- les anodes (5a, 5b, 5c) sont en ITO (oxyde d'étain-indium) ;
- l'empilement de couches organiques (8) comporte : polymères, petites molécules, matériaux phosphorescents, matériaux activables thermiquement
- le substrat transparent (4) est un substrat souple ou en verre, en silicium, en oxyde de silicium, en oxyde de silicium sur silicium, en polymère.

10. Dispositif selon l'une des revendications précédentes, dans lequel les moyens d'activation sélective et d'affichage (13) des zones actives (Z1, Z2) séparées, sont : un circuit d'impulsions du type horloge ou bascule électrique (13a), avec une sortie positive et une sortie négative, des interrupteurs (13b) commandés par le circuit d'impulsions et reliant des anodes (5a, 5b, 5c) et des cathodes (9a, 9b) à la source d'alimentation (12) du type batterie ou accumulateur ou générateur.

11. Procédé de fabrication d'un dispositif organique optoélectronique (1) du type OLED d'un dispositif d'animation de surfaces lumineuses analogiques selon l'une des revendications 1 à 10, comprenant :
➢ la réalisation sur un substrat transparent (4) des anodes (5a, 5b, 5c), par:
• dépôt d'une première couche (5) transparente et conductrice sur le substrat transparent (4), formée de plusieurs anodes (5a, 5b, 5c) transparentes et conductrices, séparées latéralement par des gravures (6) ;
• structuration prédéfinie d'un motif géométrique spécifique pour chaque anode (5a, 5b, 5c) ;
> le dépôt d'une deuxième couche isolante (7) sur des endroits de la première couche (5), servant à isoler électriquement les anodes (5a, 5b, 5c) et présentant une épaisseur e1;
> la réalisation de profils de séparation latérale (10) d'épaisseur e4 ;
> le dépôt de la troisième couche (8) de couches organiques d'épaisseur e2, par évaporation sur : les anodes (5a, 5b, 5c) séparées, la deuxième couche isolante (7), et les profils de séparation latérale (10) ;
> le dépôt de la quatrième couche métallique (9) d'épaisseur e3, par évaporation d'un métal sur les couches organiques (8) et les profils de séparation latérale (10), pour réaliser les cathodes (9a, 9b), qui sont séparées latéralement par les profils de séparation latérale (10),
l'épaisseur e4 étant supérieure à e1+e2+e3
le recouvrement des anodes (5a, 5b, 5c), de l'empilement des couches organiques (8), et des cathodes (9a, 9b) définissant des zones actives (Z1, Z2) séparées, de façon à présenter en regard:
- des anodes (5a, 5b) séparées et une cathode commune (9a) ;
- des anodes séparées et des cathodes séparées ; et/ou
- une anode commune (5b) et des cathodes (9a, 9b) séparées;
les gravures (6), les profils de séparation latérale (10) et/ou la deuxième couche isolante (7) permettant de réaliser les zones actives (Z1, Z2) séparées, avec chacune un motif géométrique spécifique et permettant l'activation d'au moins deux zones active, séparées, contiguës (Z1, Z2) dans une première et une deuxième image comprenant des zones actives séparées (Z1, Z2), l'une des deux zones actives de la deuxième image étant commune avec l'une deux zones actives de la première image.

12. Procédé de fabrication selon la revendication 11, par photolithographie et gravure, comprenant les étapes suivantes :
➢ pour la structuration des anodes (5a, 5b, 5c) :
• dépôt d'une résine photosensible (R1) sur la première couche (5) ;
• positionnement d'un masque de photolithographie (T1) dont les ouvertures permettent la structuration prédéfinie d'un motif géométrique spécifique pour chaque anode, sur la résine photosensible (R1) ;
• photolithographie par insolation de la résine photosensible (R1) à travers les premières ouvertures, développement, gravure dans la première couche (5) pour réaliser les anodes (5a, 5b, 5c) séparées et nettoyage de la résine ;
➢ pour le dépôt de la deuxième couche isolante (7) :
• dépôt d'une deuxième couche isolante (7) comprenant une résine photosensible (R2) d'épaisseur e1 sur les anodes (5a, 5b, 5c) séparées constituant la première couche (5) ;
• positionnement d'un masque de photolithographie ;
• photolithographie par insolation et développement de la deuxième couche isolante (7);
➢ pour la réalisation de profils de séparation latérale (10) :
• dépôt d'au moins une résine photosensible (R3) sur les anodes (5a, 5b, 5c) et la deuxième couche isolante (7);
• positionnement d'un masque de photolithographie (T3) dont les ouvertures permettent de réaliser les profils de séparation latérale (10) ;
• photolithographie par insolation UV et développement de la résine photosensible pour réaliser les profils de séparation latérale (10).

13. Procédé selon la revendication précédente, dans lequel avant le dépôt de la deuxième couche isolante (7) sur la première couche (5),
on réalise les étapes suivantes :
• dépôt d'une couche de résine photosensible (R2') sur les anodes (5a, 5b, 5c);
• positionnement d'un masque de photolithographie (T2') dont les ouvertures définissant les endroits où sera déposée une couche métallique pour réaliser un contour métallique et/ou des lignes métalliques (11);
• photolithographie par insolation de la couche de résine photosensible (R2') positive à travers les ouvertures, et développement ;
• dépôt de la couche métallique (11) de telle sorte que les endroits des anodes (5a, 5b, 5c) non recouverts de la deuxième couche (7) soient recouvertes de la couche métallique (11) en contact direct avec la première couche (5) ;
• nettoyage de la couche de résine photosensible (R2') pour l'enlever.

14. Procédé selon l'une des revendications 11 à 13, dans lequel on dépose une résine non photosensible (R3a) sur les anodes (5a, 5b, 5c) ou sur la deuxième couche isolante (7) puis une résine photosensible (R3b), pour réaliser des profils de séparation latérale (10) inversés qui présentent :
- une pointe (P) qui est au contact de la couche formée de plusieurs anodes (5a, 5b, 5c) séparées ou la deuxième couche isolante (7), et
- une base (B) élargie par rapport à la pointe (P) et située au-dessus de la couche formée des cathodes (9a, 9b) séparées.

15. Procédé selon l'une des revendications 12 à 14, dans lequel :
- la résine photosensible (R1) déposée sur la première couche (5) est positive ou négative,
- la résine photosensible (R2) formant la deuxième couche est négative, et
- la résine photosensible (R3) pour réaliser les profils de séparation latérale (10) est positive.

16. Procédé selon l'une des revendications 12 à 15, dans lequel les ouvertures du deuxième masque (T2) sont disposées sur la deuxième couche isolante (7), pour que la photolithographie et gravure de la deuxième couche isolante (7) laissent les espaces séparant les anodes (5a, 5b, 5c) remplis par la deuxième couche isolante (7).

17. Procédé selon l'une des revendications 11 à 16, dans lequel la première couche (5) est une couche d'ITO pour réaliser les anodes (5a, 5b, 5c), et dans lequel de l'aluminium ou de l'or-chrome est déposé par évaporation pour réaliser les cathodes (9a, 9b).

## Patentansprüche

1. Animationsvorrichtung von analogen Leuchtflächen, um sequenziell Bilder einzuschalten, um optisch durch sequenzielle elektrische Steuerung eine Bewegung von mindestens einem Element zu realisieren,
Folgendes aufweisend:
• eine optoelektronische organische Vorrichtung in der Art einer OLED (1), welche aktive Bereiche (Z1, Z2) mit jeweils einem speziellen geometrischen Motiv auf einem transparenten Substrat (4) aufweist, welches Folgendes trägt:
- eine erste Schicht (5), die aus mehreren transparenten und leitfähigen Anoden (5a, 5b, 5c) gebildet ist, die seitlich durch Gravuren (6) getrennt sind;
- eine zweite isolierende Schicht (7) an Stellen der ersten Schicht (5), die dazu dient, die Anoden (5a, 5b, 5c) elektrisch zu isolieren und eine Dicke e1 aufweist;
- eine dritte Schicht (8) mit einer Dicke e2, welche mindestens eine Stapelung organischer Schichten beinhaltet, wobei die organischen Schichten (8a), die in direktem Kontakt mit den Anoden (5a, 5b, 5c) sind, aktiv sind, während die organischen Schichten (8b), die auf der zweiten Schicht aufgebracht sind, inert sind;
- eine vierte Metallschicht (9) mit einer Dicke e3, die mehrere Kathoden (9a, 9b) aufweist, die seitlich voneinander getrennt sind, und die Stapelung organischer Schichten (8) abdeckt,
- Profile zur seitlichen Trennung (10) der Kathoden (9a, 9b) und der organischen Schichten (8) zum elektrischen Isolieren der Kathoden (9a, 9b) mit einer Dicke e4 größer als e1+e2+e3, die auf der ersten Schicht (5) oder auf der zweiten Schicht (7) aufgebracht sind,
wobei die Abdeckung der Anoden (5a, 5b, 5c), der Stapelung organischer Schichten (8) und der Kathoden (9a, 9b) getrennte aktive Bereiche (Z1, Z2) definiert, um einander gegenüber Folgendes aufzuweisen:
- Getrennte Anoden (5a, 5b), und eine gemeinsame Kathode (9a);
- getrennte Anoden und getrennte Kathoden; und/oder
- eine gemeinsame Anode (5b) und getrennte Kathoden (9a, 9b) ;
wobei die Gravuren (6), die Profile zur seitlichen Trennung (10) und/oder die zweite isolierende Schicht (7) es ermöglichen, seitlich getrennte aktive Bereiche (Z1, Z1) zu realisieren, die jeweils ein spezielles geometrisches Motiv aufweisen,
• eine Stromversorgung (12), Stromkabel und Stromkontakte, die mit den Anoden (5a, 5b, 5c) und mit den Kathoden (9a, 9b) für deren Spannungsversorgung verbunden sind, um bei einer Sequenz das Einschalten eines oder mehrerer getrennter aktiver Bereiche (Z1, Z2) zu ermöglichen,
durch eine Kombination: Einer oder mehrerer Anoden (5a, 5b, 5c) und einer oder mehrerer Kathoden (9a, 9b);
• mit den Stromkabeln verbunden, Mittel zur selektiven Aktivierung und Anzeige (13) der seitlich getrennten aktiven Bereiche (Z1, Z2), um bei jeder Sequenz eine oder getrennte aktive Bereiche (Z1, Z2) zu aktivieren und anzuzeigen, und sequenziell animierte Bilder zu bilden, wobei die Mittel zur selektiven Aktivierung und Anzeige (13) weiter konfiguriert sind, um es zu ermöglichen, Folgendes anzuzeigen:
Ein erstes Bild durch Aktivieren mindestens zweier benachbarter getrennter aktiver Bereiche (Z1, Z2), die aktiviert werden, durch die Kombination:
• einer ersten Anode und mindestens einer zweiten Anode, und
• einer ersten Kathode gegenüber der ersten Anode und der zweiten Anode,
ein zweites Bild durch Aktivieren mindestens zweier benachbarter getrennter aktiver Bereiche, die aktiviert werden, durch die Kombination:
• der ersten Kathode und einer zweiten Kathode, und
• der zweiten Anode gegenüber der ersten Kathode und der zweiten Kathode,
wobei die eine der beiden aktivierten aktiven Bereiche (Z1, Z2) in diesem zweiten Bild in dem ersten Bild aktiviert wird.

2. Vorrichtung nach dem vorstehenden Anspruch, das durch Fotolithographie und Entwicklung realisiert wird, und wobei die zweite Schicht (7) ein negatives lichtempfindliches Harz ist.

3. Vorrichtung nach einem der vorstehenden Ansprüche, wobei die Profile zur seitlichen Trennung (10) durch Fotolithographie und Entwicklung realisiert werden, und Folgendes aufweisen:
- Eine Stapelung aus zwei Harzen, die aufeinander mit einem nicht lichtempfindlichen Harz (10a) aufgebracht werden, das in Kontakt mit der ersten Schicht (5) oder der zweiten Schicht (7) aufgebracht wird, und einem positiven lichtempfindlichen Harz (10b) auf dem nicht lichtempfindlichen Harz (10a).

4. Vorrichtung nach einem der Ansprüche 1 bis 3, wobei die Profile zur seitlichen Trennung (10) eine Dicke mindestens vier Mal größer als die Summe der Dicken e1+e2+e3 aufweisen.

5. Vorrichtung nach einem der Ansprüche 1 bis 4, wobei die Profile zur seitlichen Trennung (10) umgekehrte Profile aufweisen, deren Spitze (P) in Kontakt mit der ersten Schicht (5) oder der zweiten Schicht (7) ist, und dessen in Bezug auf die Spitze (P) erweiterte Basis (B) sich oberhalb der vierten Schicht (9) befindet.

6. Vorrichtung nach einem der vorstehenden Ansprüche, wobei die Dicke der Profile zur seitlichen Trennung (10) ein bis mehrere Mikrometer beträgt.

7. Vorrichtung nach einem der vorstehenden Ansprüche, wobei die zweite isolierende Schicht (7) Farbstoffe und/oder Quantenpunkt aufweist, um das Licht zu absorbieren, das durch die getrennten aktiven Bereiche (Z1, Z2) ausgegeben wird, und erneut Licht mit einer anderen sichtbaren Wellenlänge auszugeben.

8. Vorrichtung nach einem der vorstehenden Ansprüche, wobei die optoelektronische mikroorganische Vorrichtung in der Art einer OLED eine metallische Kontur und/oder metallische Linien (11) aufweist, um die Leitfähigkeit der Anoden (5a, 5b, 5c) der ersten Schicht (5) zu erhöhen.

9. Vorrichtung nach einem der vorstehenden Ansprüche, wobei:
- Die Anoden (5a, 5b, 5c) aus ITO (Indium-Zinn-Oxid) sind;
- die Stapelung organischer Schichten (8) Folgendes beinhaltet: Polymere, kleine Moleküle, phosphoreszierende Materialien, thermisch aktivierbare Materialien
- das transparente Substrat (4) ein flexibles Substrat oder aus Glas, aus Silizium, aus Siliziumoxid, aus Siliziumoxid auf Silizium, aus Polymer ist.

10. Vorrichtung nach einem der vorstehenden Ansprüche, wobei die Mittel zur selektiven Aktivierung und Anzeige (13) der getrennten aktiven Bereiche (Z1, Z2) Folgendes sind: Eine Impulsschaltung in der Art einer Uhr oder einer elektrischen Wippe (13a) mit einem positiven Ausgang und einem negativen Ausgang, Schalter (13b), die durch die Impulsschaltung gesteuert werden, und Anoden (5a, 5b, 5c) und Kathoden (9a, 9b) mit der Versorgungsquelle (12) in der Art einer Batterie oder eines Akkus oder eines Generators verbinden.

11. Verfahren zur Herstellung einer optoelektronischen organischen Vorrichtung (1) in der Art einer OLED einer Animationsvorrichtung von analogen Leuchtflächen nach einem der Ansprüche 1 bis 10,
Folgendes umfassend:
> Realisieren eines transparenten Substrats (4) der Anoden (5a, 5b, 5c), durch:
• Aufbringen einer ersten transparenten und leitfähigen Schicht (5) auf dem transparenten Substrat (4), die aus mehreren transparenten und leitfähigen Anoden (5a, 5b, 5c) gebildet wird, die seitlich durch Gravuren (6) getrennt sind;
• Vordefiniertes Strukturieren eines spezifischen geometrischen Motivs für jede Anode (5a, 5b, 5c);
> Aufbringen einer zweiten isolierenden Schicht (7) an Stellen der ersten Schicht (5), die dazu dient, die Anoden (5a, 5b, 5c) elektrisch zu isolieren und eine Dicke e1 aufweist;
> Realisieren von Profilen zur seitlichen Trennung (10) mit einer Dicke e4;
> Aufbringen der dritten Schicht (8) aus organischen Schichten mit einer Dicke e2 durch Verdampfen auf: Den getrennten Anoden (5a, 5b, 5c), der zweiten isolierenden Schicht (7) und den Profilen zur seitlichen Trennung (10);
➢ Aufbringen der vierten Metallschicht (9) mit einer Dicke e3 durch Verdampfen eines Metalls auf den organischen Schichten (8) und den Profilen zur seitlichen Trennung (10), zum Realisieren der Kathoden (9a, 9b), die seitlich durch die Profile zur seitlichen Trennung (10) getrennt sind,
wobei die Dicke e4 größer als e1+e2+e3 ist
wobei die Abdeckung der Anoden (5a, 5b, 5c), der Stapelung organischer Schichten (8) und der Kathoden (9a, 9b) getrennte aktive Bereiche (Z1, Z2) definiert, um einander gegenüber Folgendes aufzuweisen:
- Getrennte Anoden (5a, 5b), und eine gemeinsame Kathode (9a);
- getrennte Anoden und getrennte Kathoden; und/oder
- eine gemeinsame Anode (5b) und getrennte Kathoden (9a, 9b) ;
wobei die Gravuren (6), die Profile zur seitlichen Trennung (10) und/oder die zweite isolierende Schicht (7) es ermöglichen, die getrennten aktiven Bereiche (Z1, Z1) mit jeweils einem spezifischen geometrischen Motiv zu realisieren, und die Aktivierung mindestens zweier benachbarter, getrennter aktiver Bereiche (Z1, Z2) in einem ersten und einem zweiten Bild ermöglichen, das getrennte aktive Bereiche (Z1, Z2) umfasst, wobei der eine der beiden aktiven Bereiche des zweiten Bildes mit dem einen der beiden aktiven Bereiche des ersten Bildes gemein ist.

12. Verfahren zur Herstellung nach Anspruch 11, durch Fotolithographie und Gravur, die folgenden Schritte umfassend:
➢ Zur Strukturierung der Anoden (5a, 5b, 5c):
• Aufbringen eines lichtempfindlichen Harzes (R1) auf der ersten Schicht (5);
• Positionieren einer fotolithographischen Maske (T1), deren Öffnungen die vordefinierte Strukturierung eines speziellen geometrischen Motivs für jede Anode auf dem lichtempfindlichen Harz (R1) ermöglichen;
• Fotolithographie durch Belichtung des lichtempfindlichen Harzes (R1) durch die ersten Öffnungen hindurch, Entwicklung, Gravur in der ersten Schicht (5) zum Realisieren der getrennten Anoden (5a, 5b, 5c) und Reinigen des Harzes;
> zum Aufbringen der zweiten isolierenden Schicht (7):
• Aufbringen einer zweiten isolierenden Schicht (7), umfassend ein lichtempfindliches Harz (R2) mit einer Dicke von e1 auf den getrennten Anoden (5a, 5b, 5c), das die erste Schicht (5) darstellt;
• Positionieren einer fotolithographischen Maske;
• Fotolithographie durch Belichtung und Entwicklung der zweiten isolierenden Schicht (7);
> zum Realisieren von Profilen zur seitlichen Trennung (10) :
• Aufbringen mindestens eines lichtempfindlichen Harzes (R3) auf den Anoden (5a, 5b, 5c) und der zweiten isolierenden Schicht (7);
• Positionieren einer fotolithographischen Maske (T3), deren Öffnungen es ermöglichen, die Profile zur seitlichen Trennung (10) zu realisieren;
• Fotolithographie durch UV-Belichtung und Entwicklung des lichtempfindlichen Harzes zum Realisieren der Profile zur seitlichen Trennung (10).

13. Verfahren nach dem vorstehenden Anspruch, wobei vor dem Aufbringen der zweiten isolierenden Schicht (7) auf der ersten Schicht (5),
die folgenden Schritte realisiert werden:
• Aufbringen einer Schicht aus lichtempfindlichem Harz (R2') auf den Anoden (5a, 5b, 5c);
• Positionieren einer fotolithographischen Maske (T2'), deren Öffnungen die Stellen definieren, an denen eine Metallschicht aufgebracht wird, um eine metallische Kontur und/oder metallische Linien (11) zu realisieren;
• Fotolithographie durch Belichtung der positiven Schicht aus lichtempfindlichem Harz (R2') durch die Öffnungen hindurch, und Entwickeln;
• Aufbringen der Metallschicht (11) derart, dass die Stellen der Anoden (5a, 5b, 5c), die nicht von der zweiten Schicht (7) abgedeckt sind, von der Metallschicht (11) in direktem Kontakt mit der ersten Schicht (5) abgedeckt werden;
• Reinigen der Schicht aus lichtempfindlichem Harz (R2') zu dessen Entfernung.

14. Verfahren nach einem der Ansprüche 11 bis 13, wobei ein nicht lichtempfindliches Harz (R3a) auf den Anoden (5a, 5b, 5c) oder auf der zweiten isolierenden Schicht (7) aufgebracht wird, und danach ein lichtempfindliches Harz (R3b), um umgekehrte Profile zur seitlichen Trennung (10) zu realisieren, die Folgendes aufweisen:
- eine Spitze (P), die in Kontakt mit der Schicht, die aus mehreren getrennten Anoden (5a, 5b, 5c) gebildet wird, oder der zweiten isolierenden Schicht (7) ist, und
- eine in Bezug auf die Spitze (P) erweiterte Basis (B), die sich oberhalb der von den getrennten Kathoden (9a, 9b) gebildeten Schicht befindet.

15. Verfahren nach einem der Ansprüche 12 bis 14, wobei:
- Das auf der ersten Schicht (5) aufgebrachte lichtempfindliche Harz (R1) positiv oder negativ ist,
- das lichtempfindliche Harz (R2), das die zweite Schicht bildet, negativ ist, und
- das lichtempfindliche Harz (R3) zum Realisieren der Profile zur seitlichen Trennung (10) positiv ist.

16. Verfahren nach einem der Ansprüche 12 bis 15, wobei die Öffnungen der zweiten Maske (T2) auf der zweiten isolierenden Schicht (7) angeordnet sind, damit die Fotolithographie und Gravur der zweiten isolierenden Schicht (7) die Räume belassen, die die Anoden (5a, 5b, 5c) trennen, die durch die zweite isolierende Schicht (7) gefüllt sind.

17. Verfahren nach einem der Ansprüche 11 bis 16, wobei die erste Schicht (5) eine ITO-Schicht zum Realisieren der Anoden (5a, 5b, 5c) ist, und wobei Aluminium oder Gold-Chrom durch Verdampfen zum Realisieren der Kathoden (9a, 9b) aufgebracht wird.

## Claims

1. A device for animation of analogue light surfaces, in order to sequentially light up images to visually make a movement of at least one element by sequential electrical control,
having:
• an organic optoelectronic device of the OLED type (1) having active zones (Z1, Z2) each with a specific geometric pattern, on a transparent substrate (4) which supports:
- a first layer (5) formed of several transparent and conductive anodes (5a, 5b, 5c), laterally separated by etchings (6);
- a second insulating layer (7) on locations of the first layer (5), used to electrically insulate the anodes (5a, 5b, 5c) and having a thickness e1;
- a third layer (8) with a thickness e2 including at least one stack of organic layers, the organic layers (8a) which are in direct contact with the anodes (5a, 5b, 5c) being active while the organic layers (8b), which are deposited on the second layer, being inert;
- a fourth metal layer (9) with a thickness e3 having several cathodes (9a, 9b) which are laterally separated from each other, and covering said stack of organic layers (8),
- profiles (10) for laterally separating the cathodes (9a, 9b) and the organic layers (8), to electrically insulate the cathodes (9a, 9b), with a thickness e4 which is greater than e1+e2+e3, deposited on the first layer (5) or on the second layer (7),
the covering of the anodes (5a, 5b, 5c), of the stack of organic layers (8), and of the cathodes (9a, 9b) defining separate active zones (Z1, Z2), so as to have, opposite to each other:
- separate anodes (5a, 5b) and a common cathode (9a);
- separate anodes and separate cathodes; and/or
- a common anode (5b) and separate cathodes (9a, 9b);
the etchings (6), the lateral separation profiles (10) and/or the second insulating layer (7) allowing producing the active zones (Z1, Z2) which are laterally separated, each having a specific geometric pattern,
• a power supply (12), electrical wires and electrical contacts connected to the anodes (5a, 5b, 5c) and to the cathodes (9a, 9b) for their voltage supply so as to allow during a sequence, the lighting of one or more separate active zones (Z1, Z2),
by a combination: of one or more anodes (5a, 5b, 5c), and of one or more cathodes (9a, 9b);
• connected to the electrical wires, means for selective activation and display (13) of the active zones (Z1, Z2) which are laterally separated, to activate and display at each sequence one or several separate active zones (Z1, Z2), and sequentially form animated images, the means for selective activation and display (13) being further configured to allow displaying:
a first image by activating at least two separate, contiguous active zones (Z1, Z2), which are activated by the combination:
• of a first anode and at least one second anode, and
• of a first cathode opposite to the first anode and the second anode,
a second image by activating at least two separate, contiguous active zones (Z1, Z2), which are activated by the combination:
• of the first cathode and a second cathode, and
• of the second anode opposite to the first cathode and the second cathode,
one of the two active zones (Z1, Z2) activated in this second image, being activated in the first image.

2. The device according to the preceding claim, produced by photolithography and development and wherein the second layer (7) is a negative photosensitive resin.

3. The device according to one of the preceding claims, wherein the lateral separation profiles (10) are produced by photolithography and development, and have:
- a stack of two resins deposited on top of each other with a non-photosensitive resin (10a) deposited in contact with the first layer (5) or the second layer (7), and a positive photosensitive resin (10b) on the non-photosensitive resin (10a).

4. The device according to one of the preceding claims 1 to 3, wherein the lateral separation profiles (10) have a thickness which is at least four times greater than the sum of the thicknesses e1+e2+e3.

5. The device according to one of the preceding claims 1 to 4, wherein the lateral separation profiles (10) have inverted profiles whose tip (P) is in contact with the first layer (5) or the second layer (7), and whose base (B) which is enlarged relative to the tip (P) is located above the fourth layer (9).

6. The device according to one of the preceding claims, wherein the thickness of the lateral separation profiles (10) is from one to several micrometres.

7. The device according to one of the preceding claims, wherein the second insulating layer (7) has dyes and/or quantum dots to absorb the light emitted by the separate active zones (Z1, Z2) and re-emit light at another visible wavelength.

8. The device according to one of the preceding claims, wherein the micro-organic optoelectronic device of the OLED type has a metal contour and/or metal lines (11) to increase the conductivity of the anodes (5a, 5b, 5c) of the first layer (5).

9. The device according to one of the preceding claims, wherein:
- the anodes (5a, 5b, 5c) are made of ITO (indium tin oxide);
- the stack of organic layers (8) comprises: polymers, small molecules, phosphorescent materials, thermally activable materials
- the transparent substrate (4) is a flexible or glass, silicon, silicon oxide, silicon oxide on silicon, polymer substrate.

10. The device according to one of the preceding claims, wherein the means for selective activation and display (13) of the separate active zones (Z1, Z2) are: a pulse circuit of the clock or electric flip-flop type (13a), with a positive output and a negative output, switches (13b) controlled by the pulse circuit and connecting anodes (5a, 5b, 5c) and cathodes (9a, 9b) to the power source (12) of the battery or accumulator or generator type.

11. A method for manufacturing an organic optoelectronic device (1) of the OLED type of a device for animation of analogue light surfaces according to one of claims 1 to 10, comprising:
> the production, on a transparent substrate (4), of the anodes (5a, 5b, 5c), by:
• deposition of a first transparent and conductive layer (5) on the transparent substrate (4), formed of several transparent and conductive anodes (5a, 5b, 5c), which are laterally separated by etchings (6);
• predefined structuring of a specific geometric pattern for each anode (5a, 5b, 5c);
> the deposition of a second insulating layer (7) on locations of the first layer (5), used to electrically insulate the anodes (5a, 5b, 5c) and having a thickness e1;
> the production of lateral separation profiles (10) with a thickness e4;
> the deposition of the third layer (8) of organic layers with a thickness e2, by evaporation on: the separate anodes (5a, 5b, 5c), the second insulating layer (7), and the lateral separation profiles (10);
> the deposition of the fourth metal layer (9) with a thickness e3, by evaporation of a metal on the organic layers (8) and the lateral separation profiles (10), to produce the cathodes (9a, 9b), which are laterally separated by the lateral separation profiles (10),
the thickness e4 being greater than e1+e2+e3
the covering of the anodes (5a, 5b, 5c), of the stack of organic layers (8), and of the cathodes (9a, 9b) defining separate active zones (Z1, Z2), so as to have, opposite to each other:
- separate anodes (5a, 5b) and a common cathode (9a);
- separate anodes and separate cathodes; and/or
- a common anode (5b) and separate cathodes (9a, 9b);
the etchings (6), the lateral separation profiles (10) and/or the second insulating layer (7) allowing producing the separate active zones (Z1, Z2), each with a specific geometric pattern and allowing the activation of at least two separate, contiguous active zones (Z1, Z2) in first and second images comprising separate active zones (Z1, Z2), one of the two active zones of the second image being common with one of the two active zones of the first image.

12. The manufacturing method according to claim 11, by photolithography and etching, comprising the following steps:
➢ for the structuring of the anodes (5a, 5b, 5c):
• deposition of a photosensitive resin (R1) on the first layer (5);
• positioning of a photolithography mask (T1) whose openings allow the predefined structuring of a specific geometric pattern for each anode, on the photosensitive resin (R1);
• photolithography by exposure of the photosensitive resin (R1) through the first openings, development, etching in the first layer (5) to produce the separate anodes (5a, 5b, 5c) and cleaning of the resin;
> for the deposition of the second insulating layer (7) :
• deposition of a second insulating layer (7) comprising a photosensitive resin (R2) with a thickness e1 and on the separate anodes (5a, 5b, 5c) constituting the first layer (5);
• positioning of a photolithography mask;
• photolithography by exposure and development of the second insulating layer (7);
> for the production of lateral separation profiles (10) :
• deposition of at least one photosensitive resin (R3) on the anodes (5a, 5b, 5c) and the second insulating layer (7) ;
• positioning of a photolithography mask (T3) whose openings allow producing the lateral separation profiles (10) ;
• photolithography by UV exposure and development of the photosensitive resin to produce the lateral separation profiles (10).

13. The method according to the preceding claim, wherein before the deposition of the second insulating layer (7) on the first layer (5),
the following steps are carried out:
• deposition of a layer of photosensitive resin (R2') on the anodes (5a, 5b, 5c);
• positioning of a photolithography mask (T2') whose openings define the locations where a metal layer will be deposited to produce a metal contour and/or metal lines (11) ;
• photolithography by exposure of the positive photosensitive resin layer (R2') through the openings, and development;
• deposition of the metal layer (11) such that the locations of the uncovered anodes (5a, 5b, 5c) of the second layer (7) are covered with the metal layer (11) which is in direct contact with the first layer (5);
• cleaning the photosensitive resin layer (R2') in order to remove it.

14. The method according to one of claims 11 to 13, wherein a non-photosensitive resin (R3a) is deposited on the anodes (5a, 5b, 5c) or on the second insulating layer (7) then a photosensitive resin (R3b), to produce inverted lateral separation profiles (10) which have:
- a tip (P) which is in contact with the layer formed by several separate anodes (5a, 5b, 5c) or the second insulating layer (7), and
- a base (B) which is enlarged relative to the tip (P) and located above the layer formed by the separate cathodes (9a, 9b) .

15. The method according to one of claims 12 to 14, wherein:
- the photosensitive resin (R1) deposited on the first layer (5) is positive or negative,
- the photosensitive resin (R2) forming the second layer is negative, and
- the photosensitive resin (R3) to produce the lateral separation profiles (10) is positive.

16. The method according to one of claims 12 to 15, wherein the openings of the second mask (T2) are disposed on the second insulating layer (7), so that the photolithography and etching of the second insulating layer (7) leave the spaces separating the anodes (5a, 5b, 5c) filled by the second insulating layer (7).

17. The method according to one of claims 11 to 16, wherein the first layer (5) is an ITO layer to produce the anodes (5a, 5b, 5c), and wherein aluminium or chrome gold is deposited by evaporation to produce the cathodes (9a, 9b).
